# EUROPÄISCHE PATENTSCHRIFT

(11) **EP 4 322 716 B1**
(45) Veröffentlichungstag und Bekanntmachung des Hinweises auf die Patenterteilung: **25.02.2026**
(21) Anmeldenummer: 23190575.3
(22) Anmeldetag: 09.08.2023
(51) Int. Cl.: H05K 5/00, H05K 5/04, H01F 27/02, H05K 7/20, H05K 5/10

(54) **GEHÄUSE FÜR EINE ELEKTRISCHE SCHALTUNG UND ZUGEHÖRIGES HERSTELLUNGSVERFAHREN**
HOUSING FOR AN ELECTRICAL CIRCUIT AND CORRESPONDING PRODUCTION METHOD
BOÎTIER POUR CIRCUIT ÉLECTRIQUE ET PROCÉDÉ DE FABRICATION ASSOCIÉ

(30) Priorität: 11.08.2022 LU 502656
(43) Veröffentlichungstag der Anmeldung: 14.02.2024
(73) Patentinhaber: PHOENIX CONTACT GmbH & Co. KG, 32825 Blomberg (DE)
(72) Erfinder: Meene, Florian, 33014 Bad Driburg (DE)
(74) Vertreter: LifeTech IP Spies & Behrndt Patentanwälte PartG mbB

(56) Entgegenhaltungen:
- EP-A2- 1 845 763
- EP-A2- 2 119 970
- EP-B1- 0 040 752

## Beschreibung

Die Erfindung betrifft eine Technik zum Ausgestalten eines Gehäuses für eine elektrische Schaltung. Ohne darauf beschränkt zu sein, betrifft die Erfindung insbesondere ein Gehäuse zur Aufnahme einer elektrischen Schaltung mit optimierter Montageverbindung, beispielsweise für Metallgehäuseteile und/oder Stromversorgungen, sowie ein vereinfachtes Herstellungsverfahren hierfür.

Es existiert eine Vielzahl von Gehäusekonzepten für Stromversorgungen u.a. für den Schaltschrankeinsatz im Maschinenbau. Wichtige Anforderungen in diesem Bereich sind eine platzsparende, kostengünstige und robuste Bauform. Das Gehäusematerial ist überwiegend aus Metall bzw. Kunststoff oder einer Kombination beider Materialen, abhängig von den meist hohen elektrischen, mechanischen und thermischen Anforderungen.

Insbesondere wenn die Anforderungen für die drei Bereiche (elektrisch, mechanisch, thermisch) hoch sind, wird die Gehäusekonstruktion komplex. Somit steigen auch der Fertigungsaufwand und die Produktionskosten durch meist viele Montageverbindungen (z.B. Schrauben) und Montageschritte. Im Fall von größeren Leistungsklassen und somit höheren Verlustleistungen reicht ein Gehäuse aus dünnen Blechteilen meist nicht mehr aus, um die entstehende Wärme ausreichend abzuführen. Hier kommen dann größere Gehäusekühlkörper, oft mit Kühlrippen, zum Einsatz.

Das Dokument EP 0 040 752 B1 zeigt ein Elektronikgehäuse aus zwei gegenüberliegenden Kühlkörpern als Halbschalen mit Kühlrippen. Die Kühlkörper werden über die gesamte Länge durch eine Vielzahl von Querbolzen verbunden, die eine Montagebewegung quer zur Längsrichtung erfordern.

Das Dokument EP 2 119 970 A2 zeigt ein Montagesystem für eine elektromechanische Entlüftung, bei dem ein zusätzlicher Montagebügel die Seitenwände in einem definierten Abstand hält. Der Montagebügel ist formschlüssig mit den Seitenwänden verbunden.

Das Dokument EP 1 845 763 A2 betrifft ein Gehäuse für die Aufnahme von Leiterkarten, elektronischen und/oder elektrischen Komponenten oder dergleichen, wobei das Gehäuse im Wesentlichen aus zwei gleichartig ausgebildeten Profilen besteht, von denen das eine Profil (2) den Boden (5) und eine erste Seitenwand (1 1) des Gehäuses (1) und das zweite Profil (3) die Decke (7) und die zweite Seitenwand (13) des Gehäuses (1) bildet,.

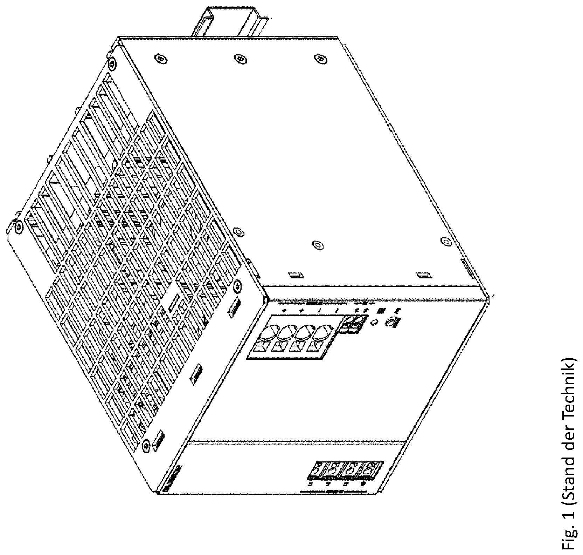

**Fig. 1** zeigt ein Referenzbeispiel eines Gehäuses aus dem Stand der Technik. Das Gehäuse weist mehrere Schraubrichtungen auf. Ferner sind Schrauben im Bereich der Lüftungsgitter und Gehäusekühlkörper im hinteren Bereich nahe der Tragschiene.

Der Erfindung liegt daher die Aufgabe zu Grunde, eine Technik anzugeben, die ein den obigen Anforderungen entsprechendes Gehäuse mit reduziertem Montageaufwand und damit möglichst kostengünstig realisiert. Dabei ist es wünschenswert, insbesondere die Anzahl der Montagerichtungen der verwendeten Schrauben zu minimieren, da der Montageaufwand mit jeder zusätzlichen Montagerichtung deutlich ansteigt. Eine alternative oder spezifischere Aufgabe ist, eine fertigungsoptimierte, robuste Montageverbindung von Blechgehäuseteilen und Gehäusekühlkörper mit reduzierten Schraubumfang anzugeben.

Die Aufgabe wird bzw. die Aufgabe werden mit den Merkmalen jedes der unabhängigen Ansprüche gelöst. Zweckmäßige Ausgestaltungen und vorteilhafte Weiterbildungen der Erfindung sind in den abhängigen Ansprüchen angegeben.

Ausführungsbeispiele der Erfindung, die wahlweise miteinander kombinierbar sind, sind im Folgenden unter teilweiser Bezugnahme auf die Figuren offenbart.

Ein erster Aspekt betrifft ein Gehäuse zur Aufnahme einer elektrischen Schaltung. Das Gehäuse ist zusammengesetzt aus mindestens einer Rückwand, zwei zueinander parallelen Gehäusekühlkörpern, und/oder zwei zueinander parallelen Seitenwänden.

Die Rückwand erstreckt sich in einer ersten Querrichtung und einer zweiten Querrichtung.

Die zwei Gehäusekühlkörper erstrecken sich in einer Montagerichtung und der ersten Querrichtung. Die erste Querrichtung ist quer zur Montagerichtung sein. Jeder der zwei Gehäusekühlkörper ist an einer Gehäuserückseite mit der Rückwand in der Montagerichtung verschraubt oder verschraubbar sein. Jeder der Gehäusekühlkörper weist an einer Gehäusefrontseite zwei sich in der Montagerichtung erstreckende Haltezapfen auf.

Die zwei Seitenwände erstrecken sich in der Montagerichtung und der zweiten Querrichtung. Die zweite Querrichtung ist quer zur Montagerichtung und/oder quer zur ersten Querrichtung sein. Jede der zwei Seitenwände weist an der Gehäusefrontseite Haltezapfenöffnungen auf. Die Haltezapfenöffnungen (beispielsweise je Seitenwand) nehmen einen der zwei Haltezapfen jedes der zwei Gehäusekühlkörper formschlüssig (beispielsweise bezüglich der ersten Querrichtung und der zweiten Querrichtung) auf oder vermögen einen der zwei Haltezapfen aufzunehmen. Im Zustand der in den Haltezapfenöffnungen aufgenommenen Haltezapfen ist jede der zwei Seitenwände an der Gehäuserückseite mit der Rückwand in der Montagerichtung verschraubt oder verschraubbar sein.

Ausführungsbeispiele können, indem jede Seitenwand an der Rückwand in der Montagerichtung verschraubt oder verschraubbar ist, den aufgenommenen Zustand (d.h. den Zustand der in den jeweiligen Haltezapfenöffnungen aufgenommenen Haltezapfen) bezüglich der Montagerichtung sichern (d.h. der Haltezapfen kann gegen eine Entnahme des Haltezapfens aus der jeweiligen Haltezapfenöffnung in der Montagerichtung gesichert sein). Durch den so gesicherten aufgenommen Zustand sind aufgrund des Formschlusses bezüglich der ersten Querrichtung und der zweiten Querrichtung die Gehäusekühlkörper und die Seitenwände an der Gehäusefrontseite zuverlässig miteinander mechanisch verbunden, ohne dass eine weitere Verschraubung an der Gehäusefrontseite und/oder in einer anderen Richtung als der Montagerichtung notwendig ist.

Diese oder weitere Ausführungsbeispiele können eine optimierte Montageverbindung für die Kombination von Blechgehäuseteilen mit Gehäusekühlkörpern elektrischer Geräte ermöglichen.

Hierin schließt eine Bezugnahme auf zwei Gehäusekühlkörper nicht aus, dass das Gehäuse einen dritten oder weitere Gehäusekühlkörper umfasst. Alternativ oder ergänzend schließt eine Bezugnahme auf zwei Seitenwände nicht aus, dass das Gehäuse eine dritte oder weitere Seitenwände umfasst. Alternativ oder ergänzend schließt eine Bezugnahme auf zwei Haltezapfenöffnungen nicht aus, dass eine oder jede der Seitenwände eine dritte oder weitere Haltezapfenöffnungen (beispielsweise zur Aufnahme eines der Haltezapfen) umfasst. Alternativ oder ergänzend schließt eine Bezugnahme auf zwei Haltezapfen nicht aus, dass einer oder jeder der Gehäusekühlkörper einen dritten oder weitere Haltezapfen umfasst.

Die Gehäusefrontseite kann in der Montagerichtung der Gehäuserückseite gegenüberliegen.

Jeder der Gehäusekühlkörper kann an der Gehäuserückseite Sacklöcher mit einem Innengewinde aufweisen. Die Rückwand kann Durchgangslöcher aufweisen, welche mit den Sacklöchern zum Verschrauben des jeweiligen Gehäusekühlkörpers mit der Rückwand in Flucht stehen.

Die erste Querrichtung kann senkrecht zur Montagerichtung sein. Alternativ oder ergänzend kann die zweite Querrichtung senkrecht zur Montagerichtung und/oder senkrecht zur ersten Querrichtung sein. Die Rückwand kann senkrecht auf die Gehäusekühlkörper geschraubt sein.

Die Seitenwände können rechteckig sein. Alternativ oder ergänzend können die Gehäusekühlkörper rechteckig sein.

Die zwei Seitenkanten jeder der Seitenwände können jeweils einen der Gehäusekühlkörper berühren. Alternativ oder ergänzend kann sich jede der zwei Seitenkanten der Seitenwände entlang einer Seitenkante der Gehäusekühlkörper erstrecken.

Jeder der Gehäusekühlkörper kann eine geschlossene Seitenfläche des Gehäuses bilden. Alternativ oder ergänzend können die Gehäusekühlkörper und die Seitenwände (um eine der Montagerichtung entsprechenden Achse) umlaufend angeordnet sein.

Einer oder jeder der Gehäusekühlkörper kann auf seiner Innenfläche eine Leiterplatte der elektrischen Schaltung tragen. Alternativ oder ergänzend kann einer oder jeder der Gehäusekühlkörper auf seiner Außenfläche Kühlrippen zur Abgabe von Wärme der elektrischen Schaltung aufweisen.

Der Gehäusekühlkörper oder die Gehäusekühlkörper mit jeweils drauf vormontierter Leiterplatte kann bzw. können eine vormontierte Baugruppe zur Montage des Gehäuses (beispielsweise einer entsprechenden elektrischen Vorrichtung) bilden.

Die Kühlrippen können sich in der ersten Querrichtung erstrecken, beispielsweise durchgehend und/oder über die Länge des jeweiligen Gehäusekühlkörpers in der ersten Querrichtung.

Die Kühlrippen können einen Abschnitt der Außenfläche umfassen. Die Seitenwände können an einer oder jeder ihrer sich in der Montagerichtung erstreckenden Längskanten eine dem Abschnitt entsprechende Ausnehmung aufweisen. Durch die Ausnehmung können die Kühlrippen in der ersten Querrichtung freiliegen.

Die Ausnehmung kann einer Verjüngung der Seitenwand oder der Seitenwände in der zweiten Querrichtung entsprechen. Alternativ oder ergänzend kann eine Größe der Ausnehmung in der zweiten Querrichtung einer Größe der Kühlrippen in der zweiten Querrichtung entsprechen.

Eine oder jede der Seitenwände kann Lüftungsöffnungen aufweisen, beispielsweise zur Zirkulation von Luft zwischen dem Inneren und dem Äußeren des Gehäuses. Lüftungsöffnungen können gemäß einem Gitter (beispielsweise einem Ausschnitt eines Bravais-Gitters) angeordnet sein. Das Gitter kann rechtwinklig oder schiefwinklig sein.

Eine oder jede der Seitenwände kann die Lüftungsöffnungen in der Montagerichtung über die gesamte Länge der jeweiligen Seitenwand aufweisen (beispielsweise bis auf Rastausnehmungen zur Aufnahme von Rastelementen einer Frontkappe) oder über eine Länge, die größer ist als der Abschnitt mit den Kühlrippen des Gehäusekühlkörpers oder der Gehäusekühlkörper. Alternativ oder ergänzend kann eine oder jede der Seitenwände die Lüftungsöffnungen in der zweiten Querrichtung über die gesamte Länge der Seitenwand aufweisen.

Eine oder jede der Seitenwände kann Lüftungsöffnungen aufweisen mit einem Flächenanteil von mehr als der Hälfte der (beispielsweise konvexen Außenhülle der) jeweiligen Seitenwand.

Eine oder jede der Seitenwände kann an der Gehäusefrontseite einen sich in der ersten Querrichtung und der zweiten Querrichtung erstreckenden Frontsteg umfassen. Der Frontsteg kann die Haltezapfenöffnungen aufweisen. Durch den Frontsteg kann eine Biegesteifigkeit der Seitenwände an der Gehäusefrontseite ohne Verschraubungen mit einer Frontkappe erreicht werden.

Alternativ oder ergänzend kann eine oder jede der Seitenwände (beispielsweise einzelne) Ösen umfassen, die von den Seitenwänden parallel zur ersten Querrichtung auskragen und die Haltezapfenöffnungen umfassen.

Eine oder jede der Seitenwände kann an der Gehäuserückseite parallel zur ersten Querrichtung auskragende Zungen umfassen. Die Zungen können Schrauböffnungen (beispielsweise kann jede Zunge jeweils eine Schrauböffnung) zum Verschrauben der jeweiligen Seitenwand mit der Rückwand aufweisen.

Die Schrauböffnungen können ein Innengewinde aufweisen zum Verschrauben der jeweiligen Seitenwand an der Gehäuserückseite mit der Rückwand. Alternativ oder ergänzend können selbstschneidende Schrauben zum Verschrauben der jeweiligen Seitenwand mit der Rückwand an der Gehäuserückseite verwendet werden.

Alternativ oder ergänzend kann die Rückwand weitere Durchgangslöcher aufweisen. Die weiteren Durchgangslöcher können mit den Schrauböffnungen zum Verschrauben der jeweiligen Seitenwand an der Gehäuserückseite mit der Rückwand in Flucht stehen. Beispielsweise kann ein erster Satz von Schrauben die Rückwand mit den Gehäusekühlkörpern verbinden. Ein vom ersten Satz verschiedener (beispielsweise disjunkter) zweiter Satz von Schrauben kann die Seitenwände (beispielsweise in den Schrauböffnungen der Seitenwände) mit der Rückwand (beispielsweise über die weiteren Durchgangslöcher in der Rückwand) verbinden.

Alternativ oder ergänzend können die Schrauböffnungen (beispielsweise alle oder einzelne Schrauböffnungen) zum Verschrauben der jeweiligen Seitenwand mit der Rückwand in Flucht stehen mit Innengewinden der Gehäusekühlkörper an der Gehäuserückseite. Das Verschrauben der Gehäusekühlkörper mit der Rückwand und das Verschrauben der jeweiligen Seitenwände mit der Rückwand kann gemeinsame Schraubverbindungen umfassen.

Optional können die Schrauböffnungen zum Verschrauben der jeweiligen Seitenwand mit der Rückwand in Flucht mit Innengewinden in den Gehäusekühlkörpern stehen, so dass das Verschrauben der Gehäusekühlkörper mit der Rückwand und das Verschrauben der jeweiligen Seitenwände mit der Rückwand in einem Montageschritt erfolgen kann und/oder dieselben Schraubverbindungen nutzt. Beispielsweise können dieselben Schrauben die Seitenwände und die Rückwand mit den Gehäusekühlkörpern verbinden. Dadurch kann die Anzahl der Montageschritte weiter reduziert werden.

Die zwei Haltezapfen (beispielsweise jeder der zwei Gehäusekühlkörper) können in der ersten Querrichtung voneinander beabstandet sein. Beispielsweise können die zwei Haltezapfen (beispielsweise jeder der zwei Gehäusekühlkörper) randständig am jeweiligen Gehäusekühlkörper angeordnet sein.

Indem die zwei Haltezapfen voneinander beanstandet sind (beispielsweise nahe am sich in der Montagerichtung ersteckenden Rand angeordnet sind) können die Steckverbindungen die Gehäusekühlkörper und die Seitenwänden verwindungssteif verbinden. Alternativ oder ergänzend kann, indem die zwei Haltezapfen nahe am (sich in der Montagerichtung ersteckenden) Rand angeordnet sind, der Frontsteg in der ersten Querrichtung kurz sein.

Das Gehäuse kann ferner eine Frontkappe umfassen. Die Frontkappe kann an der Gehäusefrontseite entgegen der Montagerichtung auf die Seitenwände und/oder die Gehäusekühlkörper aufgesteckt oder aufsteckbar sein.

Die Frontkappe kann Rastelemente umfassen. Die Seitenwände und/oder die Gehäusekühlkörper können Rastausnehmungen umfassen, die dazu angeordnet sind, die Rastelemente (beispielsweise verrastet oder elastisch verriegelnd) aufzunehmen, wenn die Frontkappe aufgesteckt ist.

Alternativ oder ergänzend kann die Frontkappe erste Rastelemente umfassen, die beispielsweise an in der ersten Querrichtung gegenüberliegenden und/oder sich in der zweiten Querrichtung ersteckenden Kanten der Frontkappe angeordnet sind. Die Seitenwände können erste Rastausnehmungen (beispielsweise Schlitze) umfassen, die dazu angeordnet sind, die ersten Rastelemente aufzunehmen, wenn die Frontkappe aufgesteckt ist. Optional können die ersten Rastausnehmungen Teil eines Gitters der Lüftungsöffnungen sein. Alternativ oder ergänzend kann die Frontkappe zweite Rastelemente umfassen, die an in der zweiten Querrichtung gegenüberliegenden und/oder sich in der ersten Querrichtung ersteckenden Kanten der Frontkappe angeordnet sind. Die Gehäusekühlkörper können zweite Rastausnehmungen (beispielsweise Schlitze) umfassen, die dazu angeordnet sind, die zweiten Rastelemente aufzunehmen, wenn die Frontkappe aufgesteckt ist.

Die Frontkappe kann Führungsstifte umfassen. Die Seitenwände und/oder die Gehäusekühlkörper können Führungsbrücken umfassen, die dazu angeordnet sind, die Führungsstifte entgegen der Montagerichtung aufzunehmen, wenn die Frontkappe aufgesteckt ist.

Die Frontkappe kann erste Führungsstifte umfassen, die beispielsweise an in der ersten Querrichtung gegenüberliegenden und/oder sich in der zweiten Querrichtung ersteckenden Kanten der Frontkappe angeordnet sind. Die Seitenwände können erste Löcher (beispielsweise erste Führungsbrücken) aufweisen, die dazu angeordnet sind, die ersten Führungsstifte aufzunehmen, wenn die Frontkappe aufgesteckt ist. Alternativ oder ergänzend kann die Frontkappe zweite Führungsstifte umfassen, die an in der zweiten Querrichtung gegenüberliegenden und/oder sich in der ersten Querrichtung ersteckenden Kanten der Frontkappe angeordnet sind. Die Gehäusekühlkörper können zweite Löcher (beispielsweise zweite Führungsbrücken) aufweisen, die dazu angeordnet sind, die zweiten Führungsstifte aufzunehmen, wenn die Frontkappe aufgesteckt ist.

Die Gehäusekühlkörper können Aluminium, Kupfer und/oder Stahl umfassen. Alternativ oder ergänzend können die Seitenwände Aluminium, Kupfer und/oder Stahlblech umfassen.

Die Seitenwände können mit Kanten der Gehäusekühlkörper bündig abschließen. Alternativ oder ergänzend kann an der Gehäuserückseite die Rückwand mit den Seitenwänden und/oder den Gehäusekühlkörpern bündig abschließen. Alternativ oder ergänzend können an der Gehäusefrontseite die Gehäusekühlkörper und die Seitenwände bündig abschließen, beispielsweise mit der aufgesteckten Frontkappe.

Der Formschluss kann an der Gehäusefrontseite zwischen den Gehäusekühlkörpern und den Seitenwänden schraubenlos sein. Alternativ oder ergänzend kann eine mechanische Verbindung einer oder der an der Gehäusefrontseite aufgesteckten Frontkappe schraubenlos sein.

Eine Stromversorgung mit einem Gehäuse gemäß dem ersten Aspekt kann um eine Überstromschutzeinrichtung (fachsprachlich auch: "circuit breaker" oder CB) und/oder um Komponenten für eine unterbrechungsfreie Stromversorgung (UPS) ergänzt werden. Dabei können die Komponenten ebenfalls im Gehäuse angeordnet sein. Entsprechen können sich die Dimensionen der Seitenwände des Gehäuses bei einer Stromversorgung ohne CB oder UPS unterscheiden von den Dimensionen der Seitenwände des Gehäuses bei einer Stromversorgung mit CB und/oder UPS. Beispielsweise vergrößern sich die Seitenwände des Gehäuses und in dessen Folge auch die Frontkappe, sodass zum Beispiel parallel zur Leiterplatte der Stromversorgung weitere Platinen und/oder (beispielsweise höhere) Bauteile angeordnet werden können. Dabei kann die Frontkappe auch weitere Durchbrüche aufweisen, in denen weitere Bedienelemente oder elektrische Anschlüsse angeordnet sein können.

Vorzugsweise sind aus kühltechnischen Gründen die Komponenten von CB oder UPS nicht zwischen den Gehäusekühlkörpern angeordnet. Beispielswese sind die Komponenten von CB oder UPS einseitig an einem der Gehäusekühlkörper als separate Baugruppe (beispielsweise mit einem Seitenblech) befestigt. Die Baugruppe oder das Seitenblech kann sich parallel zum Gehäusekühlkörper erstrecken und/oder an der Rückwand verschraubt sein. Die Rückwand, die Frontkappe und die beide Seitenwände sind auf das für die Baugruppe erforderliche Maß vergrößert.

Die separate Baugruppe und/oder das Seitenblech können außerhalb der zwei zueinander parallelen Gehäusekühlkörper angeordnet sein. Beispielsweise können sich die Frontkappe und/oder die Rückwand und/oder die zwei Seitenwände in der zweiten Querrichtung über einen der Gehäusekühlkörper hinaus erstrecken, und optional durch das sich in der Montagerichtung und der ersten Querrichtung ersteckende Seitenblech geschlossen sein. Die separate Baugruppe kann zwischen dem einen der Gehäusekühlkörper und dem Seitenblech angeordnet sein. Beispielsweise können dadurch trotz unterschiedlichem Funktionsausbau verschiedener Gehäuse die beiden Gehäusekühlkörper im gleichen Abstand zueinander bei den verschiedenen Gehäusen montiert werden.

Ein zweiter Aspekt betrifft einen Satz mehrerer Stromversorgungen. Jede Stromversorgung umfasst ein Gehäuse gemäß einem Ausführungsbeispiel des ersten Aspekts mit in der Montagerichtung und der ersten Querrichtung einheitlichen oder einheitlich dimensionierten Gehäusekühlkörpern. Der Satz umfasst mindestens eine Stromversorgung, die im Gehäuse um eine Überstromschutzeinrichtung (CB) und/oder Komponenten zur unterbrechungsfreien Stromversorgung (UPS) ergänzt ist. Die Seitenwände, die Rückwand und/oder gegebenenfalls die Frontkappe des Gehäuses der mindestens einen Stromversorgung mit Überstromschutzeinrichtung und/oder Komponenten zur unterbrechungsfreien Stromversorgung sind in der zweiten Querrichtung größer als bei den Gehäusen einer Stromversorgung des Satzes ohne Überstromschutzeinrichtung und/oder ohne Komponenten zur unterbrechungsfreien Stromversorgung.

Vorteilhaft können so gemäß Ausführungsbeispielen des ersten und/oder zweiten Aspekts auch komplexere Stromversorgungen kompakt und montagefreundlich ausgeführt sein. So kann die Notwendigkeit entfallen, unterschiedliche Gehäuse oder zumindest unterschiedliche Gehäuseteile (beispielsweise Bauteile) für die jeweiligen Komponenten (Stromversorgung, CB, UPS) bereitzustellen.

Ein dritter Aspekt betrifft ein Verfahren zur Herstellung eines Gehäuses gemäß dem ersten und/oder zweiten Aspekt. Das Verfahren zur Herstellung eines Gehäuses umfasst einen Schritt des Bereitstellens der Merkmale (beispielsweise Bauteile) des Gehäuses nach einer Ausführungsform des ersten Aspekts. Beispielsweise kann die Leiterplatte oder können die Leiterplatten der elektrischen Schaltung auf der Innenfläche eines oder jedes der Gehäusekühlkörper vor dem Montieren des Gehäuses vormontiert werden. Alternativ oder ergänzend kann das Verfahren einen Schritt des Montierens des Gehäuses umfassen. Die Montagerichtung aller verwendeten Schrauben kann identisch sein.

Vorteilhaft kann so eine vereinfachte Montage des Gehäuses erreicht werden, da insbesondere eine einzige Schraubmontagerichtung die Komplexität der Montage geringhält. Insbesondere kann somit eine automatisierte und/oder zuverlässige Montage realisiert werden.

Nachfolgend wird die Erfindung unter Bezugnahme auf die anliegenden Zeichnungen anhand von Referenzbeispielen und bevorzugter Ausführungsformen, die wahlweise miteinander kombinierbar sind, näher erläutert.

Es zeigen:
- **Fig. 1**: eine schematische Darstellung eines bestehenden Gehäuses zur Aufnahme einer elektrischen Schaltung mit unterschiedlichen Montagerichtungen und Schraubverbindungen an mehreren Seiten;
- **Fig. 2**: eine perspektivische Darstellung eines Gehäuses zur Aufnahme einer elektrischen Schaltung gemäß einem ersten Ausführungsbeispiel;
- **Fig. 3**: eine perspektivische Darstellung eines Gehäuses zur Aufnahme einer elektrischen Schaltung gemäß einem zweiten Ausführungsbeispiel in einem vormontierten Zustand;
- **Fig. 4**: eine perspektivische Darstellung des Gehäuses zur Aufnahme einer elektrischen Schaltung gemäß dem zweiten Ausführungsbeispiel in einem montierten Zustand; und
- **Fig. 5**: ein schematisches Flussdiagramm eines Verfahrens zur Herstellung eines Gehäuses.

Hierin sind in verschiedenen Ausführungsformen gezeigte oder beschriebene Merkmale mit gleichen oder erweiterten Bezugszeichen austauschbar.

**Fig. 1** zeigt eine perspektivische Darstellung eines bestehenden Gehäuses zur Aufnahme einer elektrischen Schaltung als Referenzbeispiel, bei dessen Herstellung unterschiedlichen Montagerichtungen und Schraubverbindungen an mehreren Seiten eine Vielzahl von Arbeitsschritten erfordern. Zudem können Losteile wie Schrauben bei der Montage in benachbarte Lüftungsöffnungen fallen.

Dagegen können bei einem Ausführungsbeispiel eines Gehäuses alle Schraubverbindungen an der Rückseite sein und dieselbe Montagerichtung aufweisen. Eine Gehäusefrontseite kann durch einen Formschluss zusammengehalten werden, der (vorzugsweise nur) durch die Schraubverbindungen an der Rückseite gesichert ist. Optional kann eine Frontkappe an der Frontseite aufsteckbar sein, ohne dass diese für den mechanischen Verbund ein essentielles Bauteil ist.

Alternativ oder ergänzend ist ein Gehäuse für mindestens eine Leiterplatte (beispielsweise eine Platine) offenbart. Das Gehäuse umfasst eine Rückwand (d.h. bei der Gehäuserückseite); zwei zueinander gegenüberliegende Gehäusekühlkörper, die an der Rückwand in einer Montagerichtung verschraubt sind; und zwei zueinander gegenüberliegende Lüftungsgitter, die an der Rückwand in der Montagerichtung verschraubt sind. An einem der Rückwand gegenüberliegenden Ende des Gehäuses (d.h. bei der Gehäusefrontseite) ist jedes der Lüftungsgitter im verschraubten Zustand mit beiden Gehäusekühlkörpern formschlüssig verbunden.

Die Montagerichtung kann senkrecht zur Rückwand sein. Die Gehäusekühlkörper können zueinander parallel sein. Die Lüftungsgitter können zueinander parallel sein.

Alternativ oder ergänzend kann jeder der Gehäusekühlkörper zwei Haltezapfen aufweisen, die jeweils parallel der Montagerichtung auskragen und zum Formschluss in eine Durchgangsöffnung der beiden Lüftungsgitter greifen.

Das Gehäuse kann ferner eine Frontkappe umfassen, die am der Rückwand gegenüberliegenden Ende aufgesteckt oder aufsteckbar ist.

Alternativ oder ergänzend umfasst das Gehäuse ferner mindestens zwei Leiterplatten der elektrischen Schaltung, die jeweils an einem der Gehäusekühlkörper befestigt (beispielsweise vormontiert) ist.

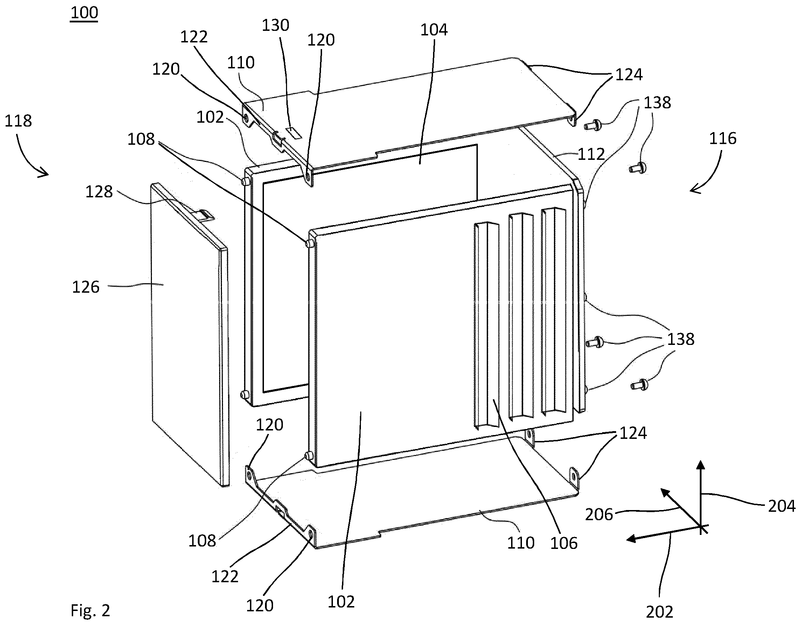

**Fig. 2** zeigt eine perspektivische Darstellung eines ersten Ausführungsbeispiels eines allgemein mit Bezugszeichen 100 bezeichneten Gehäuses zur Aufnahme einer elektrischen Schaltung. Fig. 2 ist eine Explosionszeichnung bzw. zeigt einen vormontierten Zustand des Gehäuses 100. Das Gehäuse 100 ist im Wesentlichen von der Seite dargestellt mit einem frontseitigen Anteil.

Dabei umfasst das Gehäuse 100 eine Rückwand 112, zwei zueinander parallele Gehäusekühlkörpern 102, und zwei zueinander parallele Seitenwänden 110.

Die Rückwand 112 kann sich in einer ersten Querrichtung 204 und einer zweiten Querrichtung 206 erstrecken.

Die zwei Gehäusekühlkörper 102 können sich in einer Montagerichtung 202 und der ersten Querrichtung 204 erstrecken. Die erste Querrichtung 204 kann quer zur Montagerichtung 202 sein. Jeder der zwei Gehäusekühlkörper 102 kann an einer Gehäuserückseite 116 mit der Rückwand 112 in der Montagerichtung 202 verschraubt oder verschraubbar sein. Jeder der Gehäusekühlkörper 102 kann an einer Gehäusefrontseite 118 jeweils zwei sich in der Montagerichtung erstreckende Haltezapfen 108 aufweisen. Die zwei Haltezapfen 108 jeder der zwei Gehäusekühlkörper 102 können randständig am jeweiligen Gehäusekühlkörper 102 angeordnet sein.

Die zwei Seitenwände 110 können sich in der Montagerichtung 202 und der zweiten Querrichtung 206 erstrecken. Die zweite Querrichtung 206 kann quer zur Montagerichtung 202 und/oder quer zur ersten Querrichtung 204 sein. Jede der zwei Seitenwände 110 kann an der Gehäusefrontseite 118 Haltezapfenöffnungen 120 aufweisen. Die Haltezapfenöffnungen 120 (beispielsweise je Seitenwand 110) können einen der zwei Haltezapfen 108 jedes der zwei Gehäusekühlkörper 102 formschlüssig (beispielsweise bezüglich der ersten Querrichtung 204 und der zweiten Querrichtung 206) aufnehmen. Im Zustand der in den Haltezapfenöffnungen 120 aufgenommenen Haltezapfen 108 kann jede der zwei Seitenwände 110 an der Gehäuserückseite 116 mit der Rückwand 112 in der Montagerichtung 202 verschraubt oder verschraubbar sein.

Damit ist die formschlüssige Verbindung an der Gehäusefrontseite 118 zwischen Gehäusekühlkörpern 102 und Seitenwänden 110 an der Gehäuserückseite 116 gesichert ohne zusätzliche Verschraubung an der Gehäusefrontseite 118.

In einer ersten Variante jedes Ausführungsbeispiels verbinden dieselben Schraubverbindungen die Seitenwände 110 und die Gehäusekühlkörper 102 mit der Rückwand 112. In einer zweiten Variante jedes Ausführungsbeispiels (beispielsweise wie in Fig. 2 gezeigt) verbinden erste Schraubverbindungen 138 die Gehäusekühlkörper 102 mit der Rückwand 112, und zweite Schraubverbindungen 138 die Seitenwände 110 mit der Rückwand 112.

Einer oder jeder der Gehäusekühlkörper 102 kann auf seiner Innenfläche eine Leiterplatte 104 der elektrischen Schaltung tragen. Alternativ oder ergänzend kann einer oder jeder der Gehäusekühlkörper auf seiner Außenfläche Kühlrippen 106 zur Abgabe von Wärme der elektrischen Schaltung aufweisen. Der Gehäusekühlkörper oder die Gehäusekühlkörper mit jeweils drauf vormontierter Leiterplatte kann bzw. können eine vormontierte Baugruppe zur Montage des Gehäuses (beispielsweise einer entsprechenden elektrischen Vorrichtung) bilden.

Eine oder jede der Seitenwände 110 kann an der Gehäusefrontseite 118 einen sich in der ersten Querrichtung 204 und der zweiten Querrichtung 206 erstreckenden Frontsteg 122 umfassen, beispielsweise ein um 90 Grad gebogenes Ende eines Stanzteils. Der Frontsteg 122 kann die Haltezapfenöffnungen 120 aufweisen. Durch den Frontsteg 122 kann eine Biegesteifigkeit der Seitenwände 110 an der Gehäusefrontseite ohne Verschraubungen mit einer Frontkappe erreicht werden.

Eine oder jede der Seitenwände kann an der Gehäuserückseite parallel zur ersten Querrichtung 204 auskragende Zungen umfassen. Die Zungen können

Schrauböffnungen (beispielsweise kann jede Zunge jeweils eine Schrauböffnung) zum Verschrauben der jeweiligen Seitenwand 110 mit der Rückwand 112 aufweisen.

Das Gehäuse 100 kann ferner eine Frontkappe 126 umfassen. Die Frontkappe 126 kann an der Gehäusefrontseite 118 entgegen der Montagerichtung 202 auf die Seitenwände 110 und die Gehäusekühlkörper 102 aufgesteckt oder aufsteckbar sein.

Die Frontkappe 126 kann Rastelemente 128 umfassen, die sich entgegen der Montagerichtung 202 erstrecken. Die Seitenwände 110 und/oder die Gehäusekühlkörper 102 können Rastausnehmungen 130 aufweisen, die dazu angeordnet sind, die Rastelemente zum (vorzugsweise reversiblen) Verrasten aufzunehmen, wenn die Frontkappe 126 aufgesteckt ist.

Die Gehäusekühlkörper 102 können Aluminium, Kupfer und/oder Stahl umfassen. Alternativ oder ergänzend können die Seitenwände 110 Aluminium, Kupfer und/oder Stahlblech umfassen.

Das Material der Frontkappe 126 weist häufig keine elektrische (und/oder eine geringe thermische) Leitfähigkeit auf. Es wird bevorzugt aus Kunststoff hergestellt, zum Beispiel aus thermoplastischen Material. Das ist auch für die diversen Auskragungen der eigentlichen Frontkappe in Form von Rastelementen 128 und Führungsstiften vorteilhaft, die zusammen mit der eigentlichen Frontklappe 126 in einem Spritzvorgang mit demselben Material herstellbar sind.

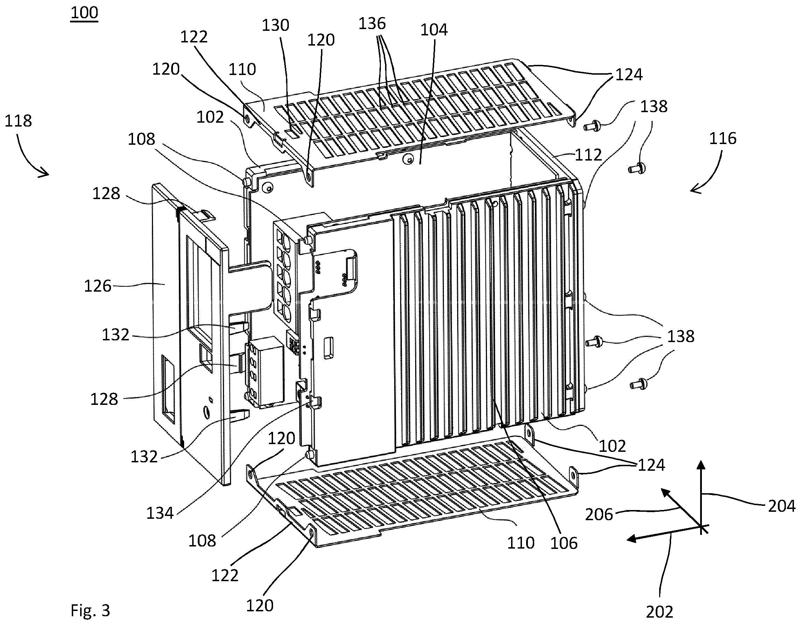

**Fig. 3** zeigt eine perspektivische Darstellung des Gehäuses 100 gemäß einem zweiten Ausführungsbeispiel in einem vormontierten Zustand. Das zweite Ausführungsbeispiel kann eine Weiterbildung des ersten Ausführungsbeispiels sein. Jedenfalls bezeichnen übereinstimmende Bezugszeichen Merkmale, welche für sich gleich oder austauschbar mit jenen des ersten Ausführungsbeispiels sein können.

Die Seitenwände 110 können Lüftungsgitterbleche umfassen. Das heißt eine oder jede der Seitenwände 110 kann Lüftungsöffnungen 136 aufweisen, beispielsweise zur Zirkulation von Luft zwischen dem Inneren und dem Äußeren des Gehäuses. Die Lüftungsöffnungen 136 können gemäß einem Gitter (beispielsweise einem Ausschnitt eines Bravais-Gitters) angeordnet sein. Das Gitter kann rechtwinklig oder (wie beispielhaft in Fig. 3 gezeigt) schiefwinklig sein. Alternativ oder ergänzend kann eine oder jede der Seitenwände 110 Lüftungsöffnungen 136 aufweisen mit einem Flächenanteil von mehr als der Hälfte der konvexen Außenhülle der jeweiligen Seitenwand 110.

Die Lüftungsöffnungen 136 können sich in der Montagerichtung 202 über die gesamte Länge der jeweiligen Seitenwand 110 erstrecken bis auf Rastausnehmungen 130 zur Aufnahme von Rastelementen 128 der Frontkappe 126. Jedenfalls können sich die Lüftungsöffnungen 136 über eine Länge erstrecken, die größer ist als ein Abschnitt mit den Kühlrippen 106 des Gehäusekühlkörpers 102.

Im vorderen Bereich (d.h. an der Gehäusefrontseite 118) besitzen beide Gehäusekühlkörper 102 jeweils in der ersten Querrichtung 204 oben und unten (beispielsweise mindestens) einen Haltezapfen 108. Über diese Haltezapfen 108 werden die Lüftungsgitterbleche 110 von vorne aufgeschoben und im hinteren Bereich (d.h. an der Gehäuserückseite 116) um die Rückwand 112 gezogen. Dort werden die Lüftungsgitterbleche 110 mit der Rückwand 112 auch von hinten (d.h. in der Montagerichtung 202) mit Schrauben 138 befestigt. Besonders dabei ist die stabile und robuste Verbindung (beispielsweise mittels des gesicherten Formschlusses) zwischen den Haltezapfen 108 und den Haltezapfenöffnungen 120 der Lüftungsgitterbleche 110 im vorderen Bereich (d.h. an der Gehäusefrontseite 118) ohne Schraubprozess.

Die Frontkappe 126 kann Führungsstifte 132 umfassen. Die Seitenwände 110 und/oder die Gehäusekühlkörper 102 können Führungsbrücken 134 umfassen, die dazu angeordnet sind, die Führungsstifte 132 entgegen der Montagerichtung 202 aufzunehmen, wenn die Frontkappe 126 aufgesteckt ist. Die Führungsstifte 132 können umlaufend an den Kanten der Frontkappe 126 angeordnet sein, beispielsweise an den sich in der ersten Querrichtung ersteckenden Kanten und an den sich in der zweiten Querrichtung ersteckenden Kanten der Frontkappe 126.

Beispielsweise wird abschließend die Frontkappe 126 von vorne (d.h. entgegen der Montagerichtung 202) in den bisherigen Aufbau geführt. Die Frontkappe 126 hat umlaufend Führungshaltestifte 132 (kurz: Führungsstifte), welche in die Führungsbrücken 134 der Gehäusekühlkörper 102 gleiten und für die genaue Positionierung der Frontkappe 126 sorgen.

Die ebenfalls in der Frontkappe 126 umlaufend angeordneten Rastelemente 128 rasten im Endanschlag in den Lüftungsgitterblechen 110 und Gehäusekühlkörper 102 ein (d.h. in den Rastausnehmungen 130 der Lüftungsgitterbleche 110 und Gehäusekühlkörper 102).

In jedem Ausführungsbeispiel können sich die Kühlrippen 106 zueinander parallel und jeweils in der ersten Querrichtung 204 erstrecken.

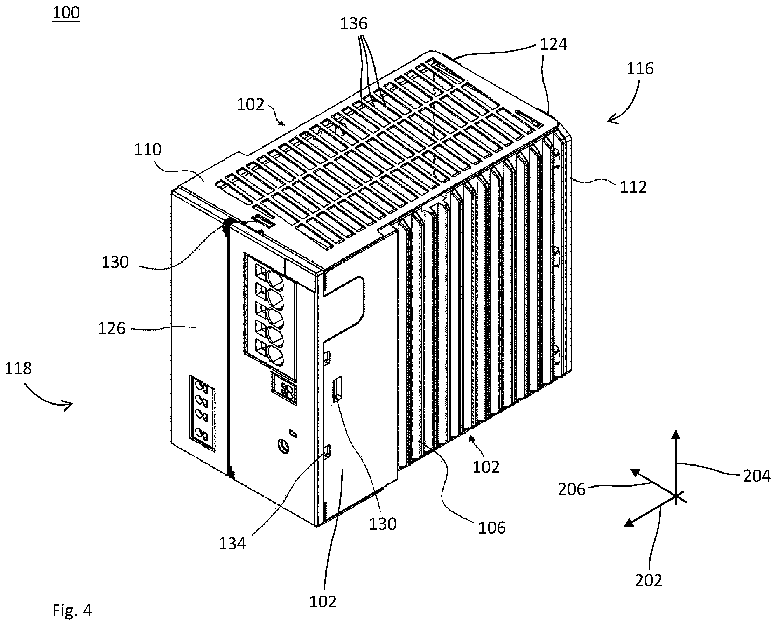

**Fig. 4** zeigt das zweite Ausführungsbeispiel im Zusammenbau. Die Kühlrippen 106 können einen Abschnitt der Außenseite (d.h. der Außenfläche) des Gehäusekühlkörpers 102 umfassen. Die Seitenwände 110 können an einer oder jeder ihrer sich in der Montagerichtung 202 erstreckenden Längskanten eine dem Abschnitt entsprechende Ausnehmung aufweisen. Durch die Ausnehmung können die Kühlrippen 106 in der ersten Querrichtung freiliegen. Die Ausnehmung kann einer Verjüngung der Seitenwand oder der Seitenwände in der zweiten Querrichtung entsprechen. Alternativ oder ergänzend kann eine Größe der Ausnehmung in der zweiten Querrichtung 206 einer Größe der Kühlrippen 106 in der zweiten Querrichtung 206 entsprechen.

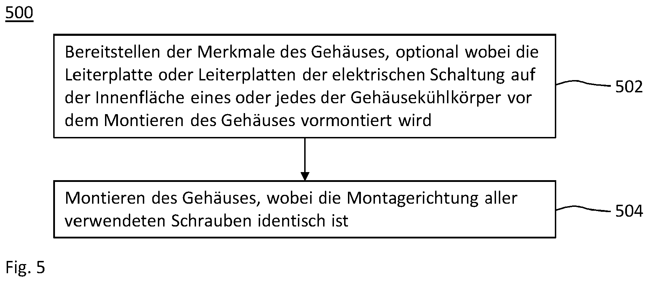

**Fig. 5** zeigt ein Flussdiagramm eines Verfahrens 500 zur Herstellung des Gehäuses 100 gemäß einem der Ausführungsbeispiele, beispielsweise ein Verfahren zur Montage der Lüftungsgitterbleche 110 und der Frontkappe 126 an die mit der Rückwand 112 verschraubten Gehäusekühlkörper 102.

Das Verfahren 500 zur Herstellung eines Gehäuses 100 kann einen Schritt des Bereitstellens 502 der Merkmale (beispielsweise Bauteile) des Gehäuses 100 nach einem Ausführungsbeispiel umfassen. Beispielsweise kann die Leiterplatte 104 (oder können die Leiterplatten 104) der elektrischen Schaltung auf der Innenfläche eines oder jedes der Gehäusekühlkörper vor dem Montieren 504 des Gehäuses 100 vormontiert werden.

Beispielsweise können im Schritt 502 für den Zusammenbau zwei Baugruppen vorbereitet werden, welche jeweils einen linken und rechten Gehäusekühlkörper 102 mit jeweils einer verschraubten Leiterplatte 104 umfasst.

Alternativ oder ergänzend kann das Verfahren einen Schritt des Montierens 504 des Gehäuses 100 umfassen. Die Montagerichtung 202 aller verwendeten Schrauben 138 kann identisch sein.

Beispielsweise werden beide Gehäusekühlkörper 102 parallel zueinander, mit den Kühlrippen 106 nach außen gerichtet, U-förmig mit der Rückwand 112 von hinten mit Schrauben 138 montiert.

Vorteilhaft kann so eine vereinfachte Montage 504 des Gehäuses 100 erreicht werden, da insbesondere eine einzige Schraubmontagerichtung 202 die Komplexität der Montage geringhält. Insbesondere kann somit eine automatisierte und/oder zuverlässige Montage realisiert werden.

In jedem Ausführungsbeispiel kann das Gehäuse 100 mit der elektrischen Schaltung eine Stromversorgung sein. Die mindestens eine Leiterplatte 104 umfasst die zugehörigen Schaltungselemente (elektronische Bauteile) der Stromversorgung. Die Stromversorgung kann in Ausführungsbeispielen um eine Überstromschutzeinrichtung (fachsprachlich "circuit breaker", CB) und/oder um Komponenten für eine unterbrechungsfreie Stromversorgung (USV oder fachsprachlich UPS) ergänzt sein, die ebenfalls im Gehäuse angeordnet sind. Ein solches Modul kann beispielsweise auf dem zweiten der zwei Gehäusekühlkörper 102 angeordnet sein angeschraubt sein (nicht gezeigt). Dabei unterscheiden sich die Dimensionen der Seitenwände 110 des Gehäuses 100 bei einer Stromversorgung ohne CB-Modul und/oder ohne UPS-Modul von den Dimensionen der Seitenwände des Gehäuses 100 bei einer Stromversorgung mit CB und/oder mit UPS in ihrer Ausdehnung in der zweiten Querrichtung 206, während die Ausdehnung der Seitenwand 110 in der ersten Querrichtung 204 einheitlich ist. Somit kommt auch eine entsprechend dimensionierte größere Rückwand 112 und Frontkappe 126 zum Einsatz.

Obwohl die Erfindung in Bezug auf exemplarische Ausführungsbeispiele beschrieben worden ist, ist für Fachkundige ersichtlich, dass verschiedene Änderungen vorgenommen werden können und Äquivalente als Ersatz verwendet werden können. Ferner können viele Modifikationen vorgenommen werden, um eine bestimmte Situation oder eine bestimmte Komponente im Gehäuse an die Lehre der Erfindung anzupassen. Folglich ist die Erfindung nicht auf die offenbarten Ausführungsbeispiele beschränkt, sondern umfasst alle Ausführungsbeispiele, die in den Bereich der beigefügten Patentansprüche fallen.

### Bezugszeichenliste

- 100: Gehäuse, beispielsweise für Stromversorgung
- 102: Gehäusekühlkörper
- 104: Leiterplatte
- 106: Kühlrippen
- 108: Haltezapfen
- 110: Seitenwände, beispielsweise Lüftungsgitterbleche
- 112: Rückwand
- 116: Gehäuserückseite
- 118: Gehäusefrontseite
- 120: Haltezapfenöffnungen
- 122: Frontsteg
- 124: Schrauböffnungen
- 126: Frontkappe
- 128: Rastelemente
- 130: Rastausnehmungen
- 132: Führungsstifte, beispielsweise Führungshaltestift
- 134: Führungsbrücken
- 136: Lüftungsöffnungen
- 138: Schrauben
- 202: Montagerichtung
- 204: Erste Querrichtung
- 206: Zweite Querrichtung
- 500: Verfahren zur Herstellung eines Gehäuses
- 502: Bereitstellen der Gehäuseteil
- 504: Montage mit identischer Montagerichtung aller verwendeten Schrauben

## Patentansprüche

1. Gehäuse (100) zur Aufnahme einer elektrischen Schaltung, zusammengesetzt aus mindestens:
einer Rückwand (112), die sich in einer ersten Querrichtung (204) und einer zweiten Querrichtung (206) erstreckt;
zwei zueinander parallelen Gehäusekühlkörpern (102), die sich in einer Montagerichtung (202) und der ersten Querrichtung (204) erstrecken, wobei die erste Querrichtung (204) quer zur Montagerichtung (202) ist, wobei jeder der zwei Gehäusekühlkörper (102) an einer Gehäuserückseite (116) mit der Rückwand (112) in der Montagerichtung (202) verschraubt oder verschraubbar ist, und wobei jeder der Gehäusekühlkörper (102) an einer Gehäusefrontseite (118) zwei sich in der Montagerichtung (202) erstreckende Haltezapfen (108) aufweist; und
zwei zueinander parallelen Seitenwänden (110), die sich in der Montagerichtung (202) und der zweiten Querrichtung (206) erstrecken, wobei die zweite Querrichtung (206) quer zur Montagerichtung (202) und quer zur ersten Querrichtung (204) ist, wobei jede der zwei Seitenwände (110) an der Gehäusefrontseite (118) Haltezapfenöffnungen (120) aufweist, die einen der zwei Haltezapfen (108) jedes der zwei Gehäusekühlkörper (102) formschlüssig bezüglich der ersten Querrichtung (204) und der zweiten Querrichtung (206) aufnehmen oder aufzunehmen vermögen, und wobei im Zustand der in den Haltezapfenöffnungen (120) aufgenommenen Haltezapfen (108) jede der zwei Seitenwände (110) an der Gehäuserückseite (116) mit der Rückwand (112) in der Montagerichtung (202) verschraubt oder verschraubbar ist.

2. Gehäuse (100) nach Anspruch 1, wobei einer oder jeder der Gehäusekühlkörper (102) auf seiner Innenfläche eine Leiterplatte (104) der elektrischen Schaltung trägt und auf seiner Außenfläche Kühlrippen (106) zur Abgabe von Wärme der elektrischen Schaltung aufweist.

3. Gehäuse (100) nach Anspruch 2, wobei sich die Kühlrippen (106) in der ersten Querrichtung (204) erstrecken, vorzugsweise durchgehend über die Länge des jeweiligen Gehäusekühlkörpers (102) in der ersten Querrichtung (204).

4. Gehäuse (100) nach Anspruch 2 oder 3, wobei die Kühlrippen (106) einen Abschnitt der Außenfläche umfassen und die Seitenwände (110) an einer oder jeder ihrer sich in der Montagerichtung (202) erstreckenden Längskanten eine dem Abschnitt entsprechende Ausnehmung aufweisen, durch welche die Kühlrippen (106) in der ersten Querrichtung (204) freiliegen.

5. Gehäuse (100) nach einem der Ansprüche 1 bis 3, wobei eine oder jede der Seitenwände (110) Lüftungsöffnungen (136) zur Zirkulation von Luft zwischen dem Inneren und dem Äußeren des Gehäuses (100) aufweist.

6. Gehäuse (100) nach einem der Ansprüche 1 bis 5, wobei eine oder jede der Seitenwände (110) an der Gehäusefrontseite (118) einen sich in der ersten Querrichtung (204) und der zweiten Querrichtung (206) erstreckenden Frontsteg (122) umfasst, welcher die Haltezapfenöffnungen (120) aufweist.

7. Gehäuse (100) nach einem der Ansprüche 1 bis 6, wobei eine oder jede der Seitenwände (110) an der Gehäuserückseite (116) parallel zur ersten Querrichtung (204) auskragende Zungen umfasst, welche Schrauböffnungen (124) zum Verschrauben der jeweiligen Seitenwand (110) mit der Rückwand (112) aufweisen.

8. Gehäuse (100) nach Anspruch 7, wobei die Schrauböffnungen (124) zum Verschrauben der jeweiligen Seitenwand (110) mit der Rückwand (112) in Flucht stehen mit Innengewinden der Gehäusekühlkörper (102) an der Gehäuserückseite (116), wobei das Verschrauben der Gehäusekühlkörper (102) mit der Rückwand und das Verschrauben der jeweiligen Seitenwände (110) mit der Rückwand gemeinsame Schraubverbindungen umfasst.

9. Gehäuse (100) nach einem der Ansprüche 1 bis 8, wobei die zwei Haltezapfen (108) jeder der zwei Gehäusekühlkörper (102) in der ersten Querrichtung (204) voneinander beabstandet sind, optional randständig am jeweiligen Gehäusekühlkörper (102) angeordnet sind.

10. Gehäuse (100) nach einem der Ansprüche 1 bis 9, ferner umfassend:
eine Frontkappe (126), die an der Gehäusefrontseite (118) entgegen der Montagerichtung (202) auf die Seitenwände (110) und/oder die Gehäusekühlkörper (102) aufgesteckt oder aufsteckbar ist.

11. Gehäuse (100) nach Anspruch 10, wobei die Frontkappe (126) Rastelemente (128) umfasst, und die Seitenwände (110) und/oder die Gehäusekühlkörper (102) Rastausnehmungen (130) umfassen, die dazu angeordnet sind, die Rastelemente (128) verrastet aufzunehmen, wenn die Frontkappe (126) aufgesteckt ist.

12. Gehäuse (100) nach Anspruch 10 oder 11, wobei die Frontkappe (126) Führungsstifte (132) umfasst, und die Seitenwände (110) und/oder die Gehäusekühlkörper (102) Führungsbrücken (134) umfassen, die dazu angeordnet sind, die Führungsstifte (132) entgegen der Montagerichtung (202) aufzunehmen, wenn die Frontkappe (126) aufgesteckt ist.

13. Gehäuse (100) nach einem der Ansprüche 1 bis 12, wobei die Gehäusekühlkörper (102) Aluminium, Kupfer und/oder Stahl umfassen, und/oder
wobei die Seitenwände (110) Aluminium, Kupfer und/oder Stahlblech umfassen.

14. Gehäuse (100) nach einem der Ansprüche 1 bis 13, wobei der Formschluss an der Gehäusefrontseite zwischen den Gehäusekühlkörpern (102) und den Seitenwänden (110) schraubenlos ist, und/oder
wobei eine mechanische Verbindung einer oder der an der Gehäusefrontseite (118) aufgesteckten Frontkappe (126) schraubenlos ist.

15. Satz mehrerer Stromversorgungen, wobei jede Stromversorgung ein Gehäuse (100) gemäß einem der Ansprüche 1 bis 14 umfasst mit in der Montagerichtung (202) und der ersten Querrichtung (204) einheitlich dimensionierten Gehäusekühlkörpern (102), wobei der Satz mindestens eine Stromversorgung umfasst, die im Gehäuse (100) um eine Überstromschutzeinrichtung und/oder Komponenten zur unterbrechungsfreien Stromversorgung ergänzt ist, und wobei die Seitenwände (110), die Rückwand (112) und/oder gegebenenfalls die Frontkappe (126) des Gehäuses (100) der mindestens einen Stromversorgung mit Überstromschutzeinrichtung oder Komponenten zur unterbrechungsfreien Stromversorgung in der zweiten Querrichtung (206) größer sind als bei den Gehäusen (100) einer Stromversorgung des Satzes ohne Überstromschutzeinrichtung oder ohne Komponenten zur unterbrechungsfreien Stromversorgung.

16. Verfahren (500) zur Herstellung eines Gehäuses (100), umfassend:
Bereitstellen (502) der Merkmale des Gehäuses (100) nach einem der Ansprüche 1 bis 14,
Aufnehmen von jeweils zwei Haltezapfen (108) der zwei parallelen Gehäusekühlkörper (102) formschlüssig in jeweils zwei Haltezapfenöffnungen (120) der zwei parallelen Seitenwände (110) an der Gehäusefrontseite (118),
Verschrauben jede der zwei Seitenwände (110) und der zwei Gehäusekühlkörper (102) an der Gehäuserückseite (116) mit der Rückwand (112) in der Montagerichtung (202) mit gemeinsame Schraubverbindungen im Zustand der in den Haltezapfenöffnungen (120) aufgenommenen Haltezapfen (108),
wobei die Montagerichtung (202) aller verwendeten Schrauben (138) identisch ist.

## Claims

1. Housing (100) for receiving an electrical circuit, assembled from at least:
a rear wall (112) extending in a first transverse direction (204) and a second transverse direction (206);
two mutually parallel housing heat sinks (102) extending in an assembly direction (202) and the first transverse direction (204), wherein the first transverse direction (204) is transverse to the assembly direction (202), wherein each of the two housing heat sinks (102) is screwed or screwable at a housing rear side (116) to the rear wall (112) in the assembly direction (202), and wherein each of the housing heat sinks (102) comprises at a housing front side (118) two retaining pins (108) extending in the assembly direction (202); and
two mutually parallel side walls (110) extending in the assembly direction (202) and the second transverse direction (206), wherein the second transverse direction (206) is transverse to the assembly direction (202) and transverse to the first transverse direction (204), wherein each of the two side walls (110) comprises at the housing front side (118) retaining-pin openings (120) which receive or are able to receive one of the two retaining pins (108) of each of the two housing heat sinks (102) in a form-fitting manner with respect to the first transverse direction (204) and the second transverse direction (206), and wherein in the state of the retaining pins (108) received in the retaining-pin openings (120) each of the two side walls (110) is screwed or screwable at the housing rear side (116) to the rear wall (112) in the assembly direction (202).

2. Housing (100) according to claim 1, wherein one or each of the housing heat sinks (102) carries on its inner surface a printed circuit board (104) of the electrical circuit and comprises on its outer surface cooling fins (106) for dissipation of heat from the electrical circuit.

3. Housing (100) according to claim 2, wherein the cooling fins (106) extend in the first transverse direction (204), preferably continuously over the length of the respective housing heat sink (102) in the first transverse direction (204).

4. Housing (100) according to claim 2 or 3, wherein the cooling fins (106) comprise a portion of the outer surface and the side walls (110) comprise at one or each of their longitudinal edges extending in the assembly direction (202) a recess corresponding to the portion, through which the cooling fins (106) are exposed in the first transverse direction (204).

5. Housing (100) according to any one of claims 1 to 3, wherein one or each of the side walls (110) comprises ventilation openings (136) for circulation of air between the interior and the exterior of the housing (100).

6. Housing (100) according to any one of claims 1 to 5, wherein one or each of the side walls (110) comprises at the housing front side (118) a front web (122) extending in the first transverse direction (204) and the second transverse direction (206), which front web comprises the retaining-pin openings (120).

7. Housing (100) according to any one of claims 1 to 6, wherein one or each of the side walls (110) comprises at the housing rear side (116) tabs projecting parallel to the first transverse direction (204), which tabs comprise screw openings (124) for screwing the respective side wall (110) to the rear wall (112).

8. Housing (100) according to claim 7, wherein the screw openings (124) for screwing the respective side wall (110) to the rear wall (112) are aligned with internal threads of the housing heat sinks (102) at the housing rear side (116), wherein the screwing of the housing heat sinks (102) to the rear wall and the screwing of the respective side walls (110) to the rear wall comprises common screw joints.

9. Housing (100) according to any one of claims 1 to 8, wherein the two retaining pins (108) of each of the two housing heat sinks (102) are spaced apart from one another in the first transverse direction (204), optionally are arranged at the edge of the respective housing heat sink (102).

10. Housing (100) according to any one of claims 1 to 9, further comprising:
a front cap (126) which is plugged on or pluggable at the housing front side (118) opposite to the assembly direction (202) onto the side walls (110) and/or the housing heat sinks (102).

11. Housing (100) according to claim 10, wherein the front cap (126) comprises detent elements (128), and the side walls (110) and/or the housing heat sinks (102) comprise detent recesses (130) which are arranged to receive the detent elements (128) in latched engagement when the front cap (126) is plugged on.

12. Housing (100) according to claim 10 or 11, wherein the front cap (126) comprises guide pins (132), and the side walls (110) and/or the housing heat sinks (102) comprise guide bridges (134) which are arranged to receive the guide pins (132) opposite to the assembly direction (202) when the front cap (126) is plugged on.

13. Housing (100) according to any one of claims 1 to 12, wherein the housing heat sinks (102) comprise aluminum, copper and/or steel, and/or
wherein the side walls (110) comprise aluminum, copper and/or sheet steel.

14. Housing (100) according to any one of claims 1 to 13, wherein the form fit at the housing front side between the housing heat sinks (102) and the side walls (110) is without screws, and/or
wherein a mechanical connection of a front cap (126) or the front cap (126) plugged on at the housing front side (118) is without screws.

15. Set of multiple power supplies, wherein each power supply comprises a housing (100) according to any one of claims 1 to 14 with housing heat sinks (102) uniformly dimensioned in the assembly direction (202) and the first transverse direction (204), wherein the set comprises at least one power supply which is supplemented in the housing (100) by an overcurrent protection device and/or components for uninterruptible power supply, and wherein the side walls (110), the rear wall (112) and/or optionally the front cap (126) of the housing (100) of the at least one power supply with overcurrent protection device or components for uninterruptible power supply are larger in the second transverse direction (206) than in the housings (100) of a power supply of the set without overcurrent protection device or without components for uninterruptible power supply.

16. Method (500) for manufacturing a housing (100), comprising:
providing (502) the features of the housing (100) according to any one of claims 1 to 14, optionally wherein the printed circuit board (104) or printed circuit boards (104) of the electrical circuit is preassembled on the inner surface of one or each of the housing heat sinks (102) before the assembling (504) of the housing (100); and
assembling (504) the housing (100), wherein the assembly direction (202) of all screws (138) used is identical.

## Revendications

1. Boîtier (100) destiné à recevoir un circuit électrique, assemblé à partir d'au moins :
une paroi arrière (112) s'étendant dans une première direction transversale (204) et une deuxième direction transversale (206) ;
deux dissipateurs thermiques de boîtier (102) parallèles l'un à l'autre s'étendant dans une direction d'assemblage (202) et la première direction transversale (204), dans lequel la première direction transversale (204) est transversale à la direction d'assemblage (202), dans lequel chacun des deux dissipateurs thermiques de boîtier (102) est vissé ou vissable à une face arrière du boîtier (116) à la paroi arrière (112) dans la direction d'assemblage (202), et dans lequel chacun des dissipateurs thermiques de boîtier (102) comprend à une face avant du boîtier (118) deux pions de retenue (108) s'étendant dans la direction d'assemblage (202) ; et
deux parois latérales (110) parallèles l'une à l'autre s'étendant dans la direction d'assemblage (202) et la deuxième direction transversale (206), dans lequel la deuxième direction transversale (206) est transversale à la direction d'assemblage (202) et transversale à la première direction transversale (204), dans lequel chacune des deux parois latérales (110) comprend à la face avant du boîtier (118) des ouvertures pour pion de retenue (120) qui reçoivent ou sont aptes à recevoir l'un des deux pions de retenue (108) de chacun des deux dissipateurs thermiques de boîtier (102) à ajustement de forme par rapport à la première direction transversale (204) et la deuxième direction transversale (206), et dans lequel dans l'état des pions de retenue (108) reçus dans les ouvertures pour pion de retenue (120) chacune des deux parois latérales (110) est vissée ou vissable à la face arrière du boîtier (116) à la paroi arrière (112) dans la direction d'assemblage (202).

2. Boîtier (100) selon la revendication 1, dans lequel l'un ou chacun des dissipateurs thermiques de boîtier (102) supporte sur sa surface intérieure une carte de circuit imprimé (104) du circuit électrique et comprend sur sa surface extérieure des ailettes de refroidissement (106) pour la dissipation de chaleur du circuit électrique.

3. Boîtier (100) selon la revendication 2, dans lequel les ailettes de refroidissement (106) s'étendent dans la première direction transversale (204), de préférence de manière continue sur la longueur du dissipateur thermique de boîtier (102) respectif dans la première direction transversale (204).

4. Boîtier (100) selon la revendication 2 ou 3, dans lequel les ailettes de refroidissement (106) comprennent une portion de la surface extérieure et les parois latérales (110) comprennent à l'une ou chacune de leurs arêtes longitudinales s'étendant dans la direction d'assemblage (202) un évidement correspondant à la portion, à travers lequel les ailettes de refroidissement (106) sont dégagées dans la première direction transversale (204).

5. Boîtier (100) selon l'une quelconque des revendications 1 à 3, dans lequel l'une ou chacune des parois latérales (110) comprend des ouvertures d'aération (136) pour la circulation d'air entre l'intérieur et l'extérieur du boîtier (100).

6. Boîtier (100) selon l'une quelconque des revendications 1 à 5, dans lequel l'une ou chacune des parois latérales (110) comprend à la face avant du boîtier (118) une âme frontale (122) s'étendant dans la première direction transversale (204) et la deuxième direction transversale (206), laquelle âme frontale comprend les ouvertures pour pion de retenue (120).

7. Boîtier (100) selon l'une quelconque des revendications 1 à 6, dans lequel l'une ou chacune des parois latérales (110) comprend à la face arrière du boîtier (116) des languettes en saillie parallèlement à la première direction transversale (204), lesquelles languettes comprennent des orifices de vis (124) pour le vissage de la paroi latérale (110) respective à la paroi arrière (112).

8. Boîtier (100) selon la revendication 7, dans lequel les orifices de vis (124) pour le vissage de la paroi latérale (110) respective à la paroi arrière (112) sont alignés avec des filetages intérieurs des dissipateurs thermiques de boîtier (102) à la face arrière du boîtier (116), dans lequel le vissage des dissipateurs thermiques de boîtier (102) à la paroi arrière et le vissage des parois latérales (110) respectives à la paroi arrière comprend des liaisons vissées communes.

9. Boîtier (100) selon l'une quelconque des revendications 1 à 8, dans lequel les deux pions de retenue (108) de chacun des deux dissipateurs thermiques de boîtier (102) sont espacés l'un de l'autre dans la première direction transversale (204), optionnellement sont disposés en bordure du dissipateur thermique de boîtier (102) respectif.

10. Boîtier (100) selon l'une quelconque des revendications 1 à 9, comprenant en outre :
un capot avant (126) qui est emboîté ou emboîtable à la face avant du boîtier (118) à l'opposé de la direction d'assemblage (202) sur les parois latérales (110) et/ou les dissipateurs thermiques de boîtier (102).

11. Boîtier (100) selon la revendication 10, dans lequel le capot avant (126) comprend des éléments de cliquetage (128), et les parois latérales (110) et/ou les dissipateurs thermiques de boîtier (102) comprennent des évidements de cliquetage (130) qui sont disposés pour recevoir les éléments de cliquetage (128) encliquetés lorsque le capot avant (126) est emboîté.

12. Boîtier (100) selon la revendication 10 ou 11, dans lequel le capot avant (126) comprend des pions de guidage (132), et les parois latérales (110) et/ou les dissipateurs thermiques de boîtier (102) comprennent des ponts de guidage (134) qui sont disposés pour recevoir les pions de guidage (132) à l'opposé de la direction d'assemblage (202) lorsque le capot avant (126) est emboîté.

13. Boîtier (100) selon l'une quelconque des revendications 1 à 12, dans lequel les dissipateurs thermiques de boîtier (102) comprennent de l'aluminium, du cuivre et/ou de l'acier, et/ou
dans lequel les parois latérales (110) comprennent de l'aluminium, du cuivre et/ou de la tôle d'acier.

14. Boîtier (100) selon l'une quelconque des revendications 1 à 13, dans lequel l'ajustement de forme à la face avant du boîtier entre les dissipateurs thermiques de boîtier (102) et les parois latérales (110) est sans vis, et/ou dans lequel une liaison mécanique d'un ou du capot avant (126) emboîté à la face avant du boîtier (118) est sans vis.

15. Jeu de plusieurs alimentations électriques, dans lequel chaque alimentation électrique comprend un boîtier (100) selon l'une quelconque des revendications 1 à 14 avec des dissipateurs thermiques de boîtier (102) de dimensions uniformes dans la direction d'assemblage (202) et la première direction transversale (204), dans lequel le jeu comprend au moins une alimentation électrique qui est complétée dans le boîtier (100) par un dispositif de protection contre les surintensités et/ou des composants pour alimentation sans interruption, et dans lequel les parois latérales (110), la paroi arrière (112) et/ou le cas échéant le capot avant (126) du boîtier (100) de l'au moins une alimentation électrique avec dispositif de protection contre les surintensités ou composants pour alimentation sans interruption sont plus grands dans la deuxième direction transversale (206) que dans les boîtiers (100) d'une alimentation électrique du jeu sans dispositif de protection contre les surintensités ou sans composants pour alimentation sans interruption.

16. Procédé (500) de fabrication d'un boîtier (100), comprenant :
fournir (502) les caractéristiques du boîtier (100) selon l'une quelconque des revendications 1 à 14, optionnellement dans lequel la carte de circuit imprimé (104) ou les cartes de circuit imprimé (104) du circuit électrique est préassemblée sur la surface intérieure de l'un ou de chacun des dissipateurs thermiques de boîtier (102) avant l'assemblage (504) du boîtier (100) ; et
assembler (504) le boîtier (100), dans lequel la direction d'assemblage (202) de toutes les vis (138) utilisées est identique.
